Europäisches Patentamt

European Patent Office

Office européen des brevets

(19)

(11) Veröffentlichungsnummer : **0 144 717**
**B1**

(12) **EUROPÄISCHE PATENTSCHRIFT**

(45) Veröffentlichungstag der Patentschrift :
**19.10.88**

(21) Anmeldenummer : **84113113.9**

(22) Anmeldetag : **31.10.84**

(51) Int. Cl.⁴ : **H 05 K 13/04, G 05 B 19/00,**
**B 23 P 19/04, B 65 G 37/02**

(54) Verfahren und Vorrichtung zur Positionierung von Bauteilen auf einem Werkstück.

(30) Priorität : **05.11.83 DE 3340084**
**05.11.83 DE 3340074**

(43) Veröffentlichungstag der Anmeldung :
**19.06.85 Patentblatt 85/25**

(45) Bekanntmachung des Hinweises auf die Patenterteilung : **19.10.88 Patentblatt 88/42**

(84) Benannte Vertragsstaaten :
**AT BE CH DE FR GB IT LI LU NL SE**

(56) Entgegenhaltungen :
**EP-A- 0 062 335**
**DE-A- 2 637 686**
**DE-A- 3 240 596**
**US-A- 3 475 805**
**US-A- 3 777 350**
**US-A- 4 116 348**

(73) Patentinhaber : **Zevatech AG**
**Römerstrasse 6**
**CH-4512 Bellach (CH)**

(72) Erfinder : **Rottmann, Maximilian R.**
**Stationsstrasse 5**
**CH-8623 Wetzikon (CH)**
Erfinder : **Tews, Uwe**
**Pestalozzistrasse 1**
**D-2080 Pinneberg (DE)**

(74) Vertreter : **Rottmann, Maximilian R.**
**c/o Rottmann + Quehl AG Glattalstrasse 37**
**CH-8052 Zürich (CH)**

## Beschreibung

Die vorliegende Erfindung bezieht sich auf ein Verfahren zur Positionierung von Bauteilen auf einem Werkstück nach dem Oberbegriff des Patentanspruches 1, sowie auf eine Vorrichtung zur Durchführung des Verfahrens.

Ein bevorzugtes Anwendungsgebiet der Erfindung ist z. B. im Aufbringen elektronischer Bauelemente auf einen Träger zu erblicken. Als Träger kommen Dickschichtschaltungen, Dünnschichtschaltungen, Leiterplatten oder ähnliche Werkstücke in Betracht. Solche Träger umfassen eine Leiterträgerplatte, die aus keramischem oder einem anderen geeigneten Material besteht, auf deren Oberfläche einerseits ein vorgegebenes Muster von elektrisch leitfähigen Bahnen und andererseits eine Mehrzahl von Anschlusspunkten zur Aufnahme von diskreten, elektrischen bzw. elektronischen Bauelementen wie z. B. Widerständen, Transistoren, Kondensatoren und dgl. vorgesehen ist. Insbesondere wegen der geringen Abmessungen und der gedrängten Anordnung von Dünnschicht- bzw. Dickschichtschaltungen ist es von ausschlaggebender Bedeutung, dass die auf den Träger aufzusetzenden Elemente mit grösstmöglichster Präzision an den vorgesehenen Platz gebracht werden, bevor sie z. B. durch Löten mit den Leiterbahnen des Trägers verbunden werden.

Im Interesse einer rationellen, möglichst weitgehend automatisierten Fertigung solcher Schaltungen werden Bestückungsautomaten verwendet, welche selbsttätig, durch ein geeignetes Programm gesteuert, Bauelemente aus einem Magazin oder aus einem ausgewählten Magazin einer Magazingruppe entnehmen, diese in den Bereich der Leiterplatte transportieren und schliesslich die Bauelemente an einer genau vorbestimmten Position auf der Leiterplatte ablegen. Die Transportvorrichtung zum Verbringen der einzelnen Bauelemente vom ausgewähltem Magazin zur vorgegebenen Position auf der Leiterplatte kann nach bekanntem Stand der Technik mit der erwünschten, hohen Präzision gesteuert werden. Andererseits ist die Lage der einzelnen Bauelemente innerhalb des Magazins nicht mit der erforderlichen Präzision gewährleistet, so dass die Position eines von der Transportvorrichtung aufgenommenen Bauelementes gegenüber einer theoretisch genauen Positionierachse der Transportvorrichtung nicht garantiert werden kann. Mit anderen Worten bedeutet das, dass ein vom Erfassungsorgan der Transportvorrichtung aus dem Magazin aufgenommenes Bauelement mehr oder weniger gegenüber der theoretischen Positionierachse der Transportvorrichtung verschoben und/oder verdreht sein kann.

Um diese nicht voraussehbare Lageverschiebung zu korrigieren, hat man bisher vorgeschlagen, die Erfassungsorgane der Transportvorrichtung mit Zentriermitteln zu versehen, um ein ungenau aufgenommenes Bauelement in die theoretisch erwünschte Sollposition gegenüber der Positionierachse zu bringen, d. h. das Bauelement mechanisch so zu verschieben, dass dessen Symmetrieachse mit der Positionierachse der Transportvorrichtung zusammenfällt. Eine solche Vorrichtung ist z. B. in der USA-Patentschrift Nr. 4 135 630 beschrieben, die eine Anordnung zum Zentrieren elektronischer Bauelemente offenbart, die aus einem Magazin entnommen worden sind und auf einer Leiterplatte aufgesetzt werden sollen. Es wird dabei von der Ueberlegung ausgegangen, dass die zu positionierenden Bauelemente während des Entnehmens aus dem Magazin möglicherweise dezentral erfasst werden und demzufolge nicht in der korrekten Sollposition auf den Leiterträger abgesetzt werden können. Um dies zu vermeiden, schlägt die genannte USA-Patentschrift die Verwendung eines Zentrierorganes vor, mit Hilfe dessen die aus dem Magazin entnommenen Bauelemente relativ zur theoretischen Positionierachse der Transportvorrichtung zentriert werden können.

An sich arbeitet dieses Verfahren bzw. diese Vorrichtung zufriedenstellend, benötigt aber in mechanischer Hinsicht aufwendige Mittel, um die im allgemeinen sehr geringe Abmessungen aufweisenden, aus dem Magazin aufgenommenen Bauelemente zu umgreifen und mechanisch zu verschieben, damit sie die theoretische Sollposition einnehmen. Die Konstruktion einer solchen Zentriervorrichtung, die sehr präzise ausgebildet sein muss, ist demzufolge aufwendig und sehr teuer.

Dazu kommt, dass mit einem die Präzision der Zentriervorrichtung beeinträchtigenden Verschleiss gerechnet werden muss, und weiter, dass unter Umständen eine Beschädigung der Bauelemente erfolgen kann. Ein weiterer Nachteil der bekannten Anordnung ist darin zu sehen, dass die bewegten Massen verhältnismässig gross sind ; im Interesse einer geringen Taktzeit beim Aufbringen der Bauelemente auf die Leiterplatte müssen deshalb die Antriebsmittel für die Transportvorrichtung, die zwangsläufig die Zentriervorrichtung umfassen müssen, überdimensioniert werden.

Schliesslich ist ein Nachteil der bekannten Anordnung darin zu sehen, dass meistens eine Mehrzahl von verschieden grossen, als Zangen ausgebildeten Zentriervorrichtungen zur Verfügung stehen muss, die auswechselbar am Greiforgan befestigt werden können, um Bauelemente unterschiedlicher Grösse zu zentrieren. Neben dem unerwünscht hohen Zeitaufwand für das Auswechseln der Zentriervorrichtungen ist auch nachteilig, dass eine Anzahl von unterschiedlichen Zentriervorrichtungen vorrätig gehalten werden muss.

In der EP-A-0 062 335 ist ein automatisches Montagesystem zur Bestückung von Leiterplatten mit elektronischen Bauelementen der gattungsgemässen Art beschrieben, welches ohne mechanische Zentriermittel arbeitet. Bei jener Vorrichtung wird das auf die Leiterplatte aufzubringende Bauteil durch ein erstes Transportorgan von einem Magazin her in den Bereich der Leiterplatte gebracht und in ein Aufnahmefach in einem zweiten Transportorgan abgelegt. Mittels dieses zweiten Transportorganes wird das Bauteil zu einen bestimmten Ort über der Leiterplatte bewegt und dort von einer höhenverstellbaren Vakuumnadel aufgenommen und abgehoben. Nun bewegt sich das zweite Transportorgan zurück und an dessen Stelle wird eine Reflektorplatte unter das Bauteil verschoben, mit Hilfe welcher das Bauteil durch einen Projektor von unten her beleuchtet wird. Eine über der Reflektorplatte angeordnete Kamera nimmt die Kontur des Bauteiles auf, und aus dem Ausgangssignal der Kamera wird dessen aktuelle Position bestimmt. Danach kann die Reflektorplatte wieder zurückgezogen werden, um den Pfad zwischen Bauteil und Leiterplatte freizugeben.

Die Leiterplatte befindet sich auf einem in X- und Y-Richtung verschiebbaren Tisch. Eine zweite Kamera bildet die Oberfläche der Leiterplatte ab und das daraus gewonnene Ausgangssignal gestattet Rückschlüsse auf die aktuelle Position der Leiterplatte. Wird von der ersten Kamera eine Lageabweichung des Bauteiles registriert, wird diese einerseits durch Rotation um die Z-Achse der Vakuumnadel und andererseits durch X/Y-Verschiebung des die Leiterplatte tragenden Tisches korrigiert, bevor das Bauteil durch Verschiebung der Vakuumnadel in Z-Richtung auf die Leiterplatte aufgesetzt wird.

Der Nachteil bei dieser Verfahrensweise ist in erster Linie der diskontinuierliche Arbeitsablauf. Das Bauteil muss vor dem Aufsetzen auf die Leiterplatte zweimal umgeladen werden. Eine Lageerfassung des Bauteils kann nur durch dazwischenschieben der Reflektorplatte, die den Bewegungspfad behindert, erfolgen ; mit anderen Worten, eine Lageerfassung während des Transportes des Bauteiles, ohne Ablegen desselben bzw. ohne Unterbruch der Transportbewegung, ist nicht möglich. Der apparative Aufwand ist sehr hoch und die Taktzeit, d. h. die Zeit von der Entnahme eines Bauteiles aus dem Magazin bis zum Aufsetzen desselben in der korrekten Position auf die Leiterplatte, ist verhältnismässig lang, einerseits durch das zweimalige Umladen des Bauteiles, andererseits durch das zwingend erforderliche Dazwischenschieben und Zurückziehen der Reflektorplatte in den bzw. aus dem vorgesehenen Bewegungspfad des Bauteiles.

Es ist zunächst die Aufgabe der vorliegenden Erfindung, ein Verfahren der gattungsgemässen Art Vorzuschlagen, welche diese Nachteile nicht mehr aufweist und insbesondere ermöglicht, Leiterplatten oder auch andere Werkstücke irgendeiner Art in rascher Folge und mit höchster Präzision mit aus einem Magazin entnommenen Bauteilen bzw. elektrischen Bauelementen zu bestücken. Es soll dabei auf die Verwendung einer komplizierten, mechanisch aufwendigen und daher teuren Zentriervorrichtung verzichtet werden.

In Bezug auf das Verfahren geht daher die Erfindung aus von einem Verfahren zur Positionierung von Bauteilen auf einem Werkstück, wie es im Oberbegriff des Patentanspruches 1 definiert ist. Zur Lösung der erfindungsgemässen Aufgabe sind die im kennzeichnenden Teil des Patentanspruches 1 angegebenen Merkmale vorgesehen.

Beim Verfahren gemäss der Erfindung wird also darauf verzichtet, das aufgenommene Bauteil mit der theoretisch optimalen Lage in Übereinstimmung zu bringen, d. h. in eine gegenüber der Positionierachse des Bauteile-Transportorganes konzentrische Position zu verschieben. Vielmehr wird das Ausmass der Exzentrizität, mit der das Bauteil erfasst wurde, und gegebenenfalls auch das Mass dessen Verdrehung, während des Transportes des Bauteiles entlang seinem Bewegungspfad zum Werkstück hin, oberhalb desselben, gemessen und anschliessend der Bewegungsablauf der Bauteile-Transportvorrichtung und/oder die Position des Werkstückes so nachgeregelt, dass schliesslich das Bauteil an der theoretisch vorgegebenen Sollposition auf das Werkstück abgesetzt bzw. in dieses eingesetzt wird. Durch den Verzicht auf Zentriervorrichtungen kann die bewegte Masse der Bauteile-Transportvorrichtung wesentlich geringer gehalten werden. Die Nachregelung, sei es der Bewegungsbahn der Transportvorrichtung, sei es der Lage des Werkstückes, kann im Rahmen der ohnehin erforderlichen Steuereinrichtung der gesamten Anlage, z. B. durch zweckentsprechende Ergänzung des Steuerprogramms, erfolgen und erfordert somit keinen zusätzlichen apparativen Aufwand.

Ein zweckmässiges Vorgehen beim erfindungsgemässen Verfahren besteht darin, dass die Lageerfassung des Bauteiles ohne Ablegen desselben erfolgt. Das Bauteil kann dabei aus dem Magazin bzw. aus einem ausgewählten Magazin der Gruppe entnommen und im Verlauf seines Transportes zum Werkstück hin in eine Lageerfassungs-Einrichtung gebracht werden. Diese Lageerfassungs-Einrichtung erkennt das Mass der Abweichung des Bauteiles gegenüber der theoretischen, zentrierten Sollage und liefert an die Steuereinrichtung ein Korrektursignal, um die Bewegungsbahn der Transportvorrichtung und/ oder die Position des Werkstückträgers zu beeinflussen bzw. nachzuregeln.

Im einfachsten Fall mag es genügen, wenn die Abweichung der Lage des Bauteiles von der theoretischen Sollage in einer einzigen, horizontal verlaufenden Richtung erfasst wird. Dies ist dann der Fall, wenn die im Magazin bzw. den Magazinen befindlichen Bauteile in der einen horizontalen Richtung sehr genau, in einer zweiten, senkrecht dazu verlaufenden Horizontalrichtung jedoch weniger genau positioniert sind. Im allgemeinen wird es jedoch erforderlich sein, die effektive Lage des Bauteiles nach dem Erfassen durch die Transportvorrichtung in zwei zueinander senkrecht stehenden, horizontalen Richtungen zu messen, nämlich in der X-Richtung und in der Y-Richtung. Dies geschieht in der Lageerfassungs-Einrichtung, deren konstruktiver Aufbau im folgenden noch eingehender erläutert werden wird.

Gegebenenfalls kann es auch erforderlich sein, neben der Erfassung der Lage des Bauteiles in X- und Y-Richtung eine allfällige Verdrehung des Bauteiles um die Positionierachse der Bauteile-Transportvorrichtung zu erkennen. Auch dies kann in der Lageerfassungs-Einrichtung geschehen, indem diese ein winkelabhängiges Fehlersignal liefert und eine Drehvorrichtung aktiviert, um das Bauteil in eine winkelgerechte Lage zu bringen.

Jedenfalls wird bzw. werden aus der Lageerfassungs-Einrichtung ein Korrektursignal oder mehrere Korrektursignale abgeleitet, die zur korrekten Positionierung des Bauteiles auf dem Werkstück Verwendung finden. Wahlweise ist es möglich, mittels dieses Korrektursignales bzw. dieser Korrektursignale entweder nur die Bewegungsbahn der Bauteile-Transportvorrichtung oder nur die Positionierung des Werkstückes zu beeinflussen, oder aber im Sinne einer Bewegungsoptimierung beide Beeinflussungen gleichzeitig vorzunehmen.

Schliesslich sei noch erwähnt, dass auf ähnliche Weise die Position des Bauteiles an der Transportvorrichtung bezüglich der Z-Richtung erfasst bzw. gemessen werden kann. Ein solcher Messwert, der ebenfalls von der Lageerfassungs-Einrichtung geliefert werden kann, bietet einen Anhaltspunkt, um das Bauteil bezüglich seiner Höhenlage optimal auf das Werkstück absetzen zu können.

Es ist eine weitere Aufgabe der vorliegenden Erfindung, eine Vorrichtung der im Oberbegriff des Patentanspruches 5 definierten Art zu schaffen, welche zur Durchführung des vorerwähnten Verfahrens geeignet ist, welche die zitierten Nachteile nicht mehr aufweist und insbesondere ermöglicht, Werkstücke, z. B. Leiterplatten für elektronische Schaltungen, in rascher Folge mit höchster Präzision mit aus einem Magazin entnommenen Bauteilen zu bestücken. Es soll dabei auf die Verwendung einer komplizierten, mechanisch aufwendigen und daher teuren Zentriervorrichtung verzichtet werden. Ausserdem soll diese Vorrichtung für sämtliche vorkommenden Bauteile-Grössen geeignet sein und somit den Benutzer von der lästigen Notwendigkeit entheben, je nach verwendetem Bauteil gegebenenfalls eine Zentriervorrichtung auswechseln zu müssen. Schliesslich soll mit der vorgeschlagenen Vorrichtung vermieden werden, dass die Bauteile beschädigt werden könnten und weiter, dass bei zunehmendem Verschleiss eine Beeinträchtigung der Genauigkeit erfolgt.

Zur Lösung dieser weiteren Erfindungsaufgabe werden bei einer Vorrichtung der gattungsgemässen Art die aus dem kennzeichnenden Teil des Patentanspruches 5 ersichtlichen Massnahmen getroffen.

Bei der erfindungsgemässen Vorrichtung wird also ebenfalls von folgender Ueberlegung ausgegangen : Es wird darauf verzichtet, das vom Greiforgan aufgenommene Bauteil unter Verwendung einer Zentriervorrichtung mit der theoretisch optimalen Lage bezüglich der Zentrierachse durch das Greiforgan in Übereinstimmung, d. h. in eine gegenüber diese Positionierachse konzentrische Position zu bringen. Vielmehr wird das Ausmass der Exzentrizität, mit der das Bauteil erfasst wurde, gemessen und anschliessend der Bewegungsablauf der Bauteile-Transportvorrichtung und/oder gegebenenfalls die Position des Werkstück-Trägers so nachgeregelt, dass das Bauteil schliesslich mit höchster Präzision an der theoretisch vorgegebenen Soll-Position auf dem Werkstück abgesetzt wird.

Wie schon erwähnt kann durch den Verzicht auf Zentriervorrichtungen die bewegte Masse der Bauteile-Transportvorrichtung wesentlich geringer gehalten werden ; dies kann sich vorteilhaft in einer verminderten Taktzeit bei gleichbleibender Antriebsleistung für die Bauteile-Transportvorrichtung oder wahlweise in einer geringeren Dimensionierung der Antriebsvorrichtung bei gleichbleibender Taktzeit niederschlagen. Die Nachregelung, sei es der Bewegungsbahn der Bauteile-Transportvorrichtung, sei es der Lage des Werkstückes, kann im Rahmen der ohnehin erforderlichen Steuereinrichtung der gesamten Anlage, z. B. durch zweckentsprechende Änderung bzw. Ergänzung des Steuerprogrammes, erfolgen und erfordert somit keinen zusätzlichen apparativen Aufwand.

Nach dem erfindungsgemässen Vorschlag ist die Lageerfassungs-Einrichtung im Bereich des Verschiebeweges des Greiforgans der Bauteile-Transportvorrichtung angeordnet. Eine zweckmässige Lösung kann darin bestehen, dass diese Lageerfassungs-Einrichtung im wesentlichen konzentrisch über der Werkstück-Halteanordnung angeordnet ist. Dies ermöglicht, dass die Bauteile-Transportvorrichtung im Verlauf ihrer Verschiebebewegung über der Werkstück-Halteanordnung kurz angehalten wird, nämlich dann, wenn das vom Greiforgan erfasste Werkstück in den Bereich der Lageerfassungs-Einrichtung gelangt ist. Während dieser kurzen Anhaltephase wird die effektive Lage des Bauteiles relativ zur durch das Greiforgan verlaufenden Positionierachse erkannt, und es wird ein Korrektursignal gebildet, welches ein Mass für die Lageabweichung in horizontaler X- und Y-Richtung sowie gegebenenfalls bezüglich Verdrehung darstellt. Da die Lageerfassungs-Einrichtung mit einem Steuergerät verbunden ist, welches dieses Korrektursignal empfängt, kann entweder die Bewegungsbahn der Bauteile-Transportvorrichtung oder die Lage des Werkstückes durch Verschieben der Werkstück-Halteanordnung nachgeregelt werden, oder aber eine Korrektur kann durch beide Massnahmen gleichzeitig erfolgen.

Eine andere Möglichkeit kann darin bestehen, dass die Lageerfassungs-Einrichtung in zumindest annähernd konzentrischer Lage an der Bauteile-Transportvorrichtung, unterhalb des Greiforganes, angeordnet ist. Diese Lösung ermöglicht ein Erfassen der effektiven Position des Bauteiles am Greiforgan während der Bewegung der Transportvorrichtung, ohne diese anzuhalten ; bezüglich der Auswertung der von der Lageerfassungs-Einrichtung gelieferten Korrektursignale gilt das vorstehend gesagte sinngemäss.

Für die Ausbildung der Lageerfassungs-Einrichtung bestehen verschiedene Möglichkeiten. Gemäss einer bevorzugten Ausführungsform kann diese ein rahmenartiges Gestell umfassen, durch welches das Greiforgan der Bauteile-Transportvorrichtung hindurchtreten kann, wobei, wie bereits erwähnt, unter Umständen ein kurzes Anhalten der Bauteile-Transportvorrichtung erfolgt, wenn sich das vom Greiforgan aufgenommene Bauteil innerhalb des rahmenartigen Gestelles befindet. Während des Durchtritts des Bauteiles durch die Lageerfassungs-Einrichtung bzw. während dieser Anhaltephase wird die effektive Lage des Bauteiles relativ zur theoretischen Positionierachse erkannt und ein Korrektursignal bzw. mehrere Korrektursignale gebildet.

Die Lageabtastung des Bauteiles kann durch Berührung oder berührungslos erfolgen. Im ersteren Fall können an den vier Seiten des vorzugsweise rechteckigen bzw. quadratischen Rahmens der Lageerfassungs-Einrichtung längsverschiebbare Nadeln vorgesehen sein, die bis zum Auftreffen auf die jeweilige Seite des Bauteiles ausgefahren werden. Das Mass der Verschiebung jeder einzelnen Nadel bildet nach entsprechender logischer Verknüpfung ein Korrektursignal, aus dem sich die Abweichung der Lage des Bauteiles von der theoretischen Soll-Lage in horizontaler X- und Y-Richtung ableiten lässt.

Im zweiten Fall kann eine berührungslose Abtastung z. B. mit Hilfe eines Laserstrahles bzw. mehrerer Laserstrahlen erfolgen. Auch hier bestehen mehrere Möglichkeiten, die in den abhängigen Ansprüchen im einzelnen definiert sind und in der nachfolgenden Beschreibung einiger Ausführungsbeispiele noch im einzelnen erörtert werden. An dieser Stelle sei nur festgehalten, dass die berührungslose Abtastung der Lage eines Bauteiles nicht nur an sich prinzipielle Vorteile bietet (wie z. B. das Fehlen jeglicher Abnutzungserscheinungen), sondern dass dadurch auch die Erfassung einer Verschwenkung des Bauteiles um die Positionierachse durch das Greiforgan, zusätzlich zur Erfassung einer Fehlpositionierung in horizontaler X- und Y-Richtung, möglich ist. Ferner ist dabei auch ein Erkennen der Höhenlage des Bauteiles möglich.

Im folgenden werden Ausführungsbeispiele der erfindungsgemässen Vorrichtung, unter Bezugnahme auf die beiliegenden Zeichnungen, näher erläutert, anhand welcher auch das erfindungsgemässe Ver- im Detail erklärt werden wird. Im einzelnen zeigen :

Fig. 1 eine schematische Darstellung einer Anordnung zur Positionierung von Bauteilen in einer Seitenansicht,

Fig. 2 eine Ansicht der Werkstück-Halteanordnung und der Bauteile-Magazingruppe der Anordnung gemäss Fig. 1 von oben,

Fig. 3-5 schematische Darstellungen der Lage eines Bauteiles innerhalb der Lageerfassungs-Einrichtung,

Fig. 6 eine schematische Aufsicht auf eine Lageerfassungs-Einrichtung mit mechanischer, berührender Abtastung,

Fig. 7 eine schematische Aufsicht auf eine erste Ausführungsform einer Lageerfassungs-Einrichtung mit berührungsloser Abtastung,

Fig. 8 eine schematische Aufsicht auf eine zweite Ausführungsform einer Lageerfassungs-Einrichtung mit berührungsloser Abtastung,

Fig. 9 dieselbe Ansicht wie Fig. 8, jedoch mit verdrehtem Bauteil,

Fig. 10 eine schematische Aufsicht auf eine dritte Ausführungsform einer Lageerfassungs-Einrichtung mit berührungsloser Abtastung, und

Fig. 11 dieselbe Ansicht wie Fig. 10, jedoch mit verdrehtem Bauteil.

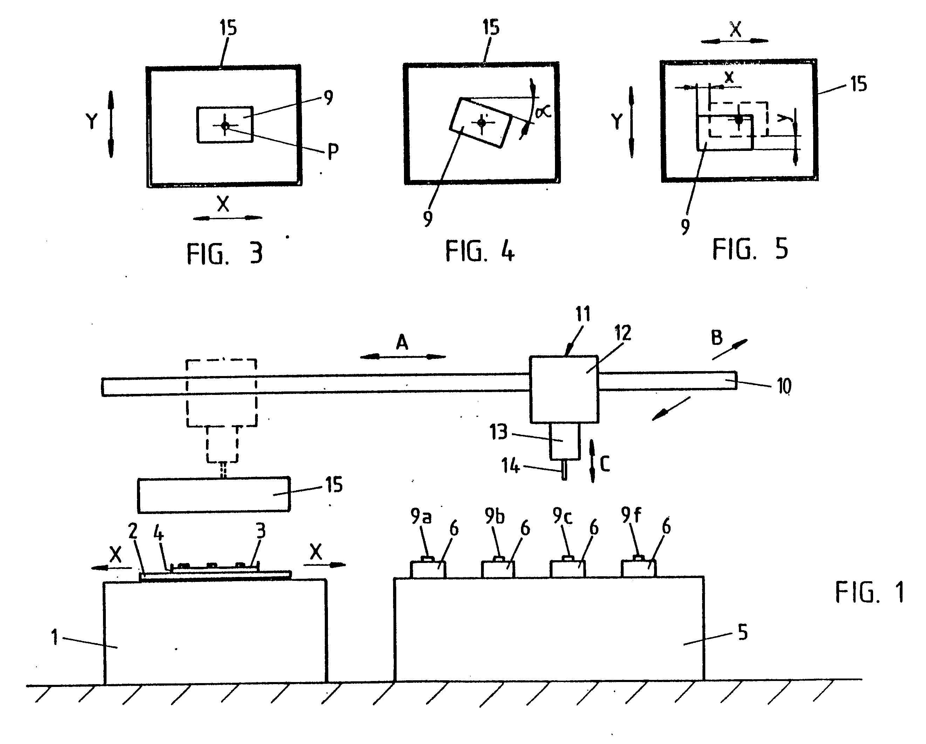

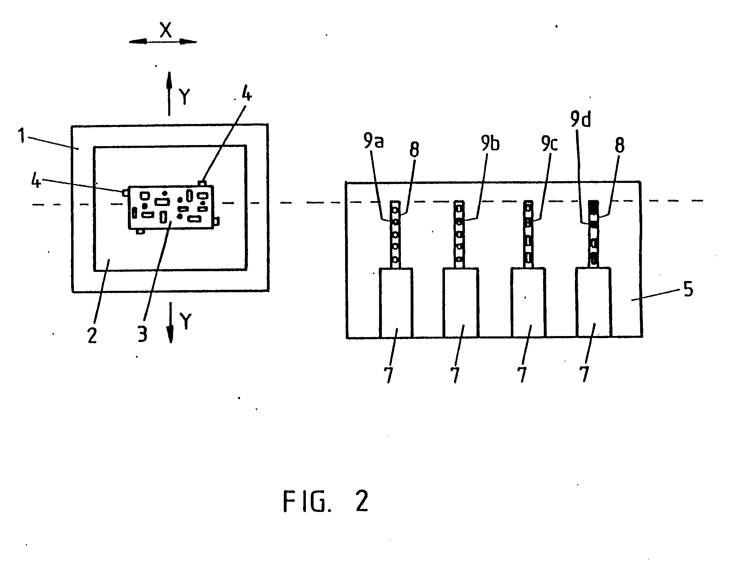

Die Einrichtung gemäss Fig. 1 umfasst eine Konsole 1, auf welcher eine Werkstück-Halteanordnung in Form eines Arbeitstisches 2 angebracht ist. Nicht näher dargestellte Antriebsorgane, die unter der Wirkung einer ebenfalls nicht dargestellten Steuereinrichtung stehen, erlauben es, den Arbeitstisch 2 horizontal in Richtung der Pfeile X wie auch in Richtung der Pfeile Y (Figur 2) zu verschieben, d. h. in zwei zueinander senkrecht stehenden Richtungen in einer Horizontalebene. Auf dem Arbeitstisch 2 ist ein Werkstück 3, z. B. in Form eines mit Leiterbahnen versehenen Keramiksubstrates, zur Herstellung einer elektronischen Schaltung angeordnet. Positionier- bzw. Halteorgane 4 dienen dazu, das Werkstück 3 gegenüber dem Arbeitstisch 2 in einer vorbestimmten Lage zu fixieren.

Eine weitere Konsole 5, die benachbart zur Konsole 1 angeordnet ist, trägt eine Anzahl von Bauelementemagazinen 6 ; diese umfassen einen Vorratsteil 7, aus welchem ein Band 8 herausragt, das mit einer Mehrzahl von z. B. aufgeklebten Bauelementen 9a, 9b usw. versehen ist. Selbstverständlich können die Bauelementemagazine 7 auch anders ausgebildet sein, und es sind eine Reihe von Betätigungsorganen für diese Magazine erforderlich ; auf diese Einzelheiten braucht im Rahmen der vorliegenden Erfindung nicht näher eingegangen zu werden, da sie im Ermessensbereich des mit der Materie vertrauten Fachmannes liegen.

Oberhalb der beiden Konsolen 1 und 5 ist eine Führung 10 angeordnet, die eine Bauteile-Transportvorrichtung 11 aufnimmt. Diese umfasst einen schlittenartigen Teil 12, der entlang der Führung 10 in Richtung des Pfeiles A längsverschiebbar ist. Vorzugsweise kann die gesamte Führung 10 zusätzlich in einer senkrecht dazu verlaufenden, horizontalen Richtung entlang des Pfeiles B querverschiebbar sein. Die Transportvorrichtung 11 umfasst ein Bauteile-Aufnahmeorgan 13, welches mit einer Hohlnadel 14 bestückt ist, um die einzelnen Bauelemente 9a-9b aus den Magazinen zu entnehmen. Das Innere der Hohlnadel 14 ist an eine (nicht dargestellte) Vakuumquelle angeschlossen ; beim Auftreffen der Spitze der Nadel 14 auf das aufzunehmende Bauelement 9 wird das Vakuum an die Nadel 14 angelegt, so dass das Bauelement 9 an der Spitze der Nadel 14

haften bleibt. Zu diesem Zweck ist die gesamte Anordnung bzw. das Bauelement-Aufnahme-organ 13 in Richtung des Pfeiles C höhenverstellbar. Das heisst, dass die Nadel 14 aus der in Figur 1 gezeigten Position auf ein ausgewähltes Bauelement 9 abgesenkt werden kann, um dieses durch Ansaugen festzuhalten.

Wie schon erwähnt, ist die Anordnung 11 entlang der Führung 10 in Richtung des Pfeiles A verschiebbar, nämlich in eine Position (gestrichelt dargestellt in Figur 1) oberhalb einer Lageerfassungs-Einrichtung 15. Letztere befindet sich zentral über dem Arbeitstisch 2 und besitzt im wesentlichen rahmenförmige Gestalt, so dass das Bauelement-Aufnahmeorgan 13 mit der das Bauelement 9 tragenden Nadel 14 durch diese hindurchtreten kann.

Auf nähere Einzelheiten bezüglich der Lageerfassungs-Einrichtung 15 wird im folgenden noch ausführlich eingegangen werden. Jedenfalls ist die Lageerfassungs-Einrichtung im Stande, die effektive Position eines Bauelementes 9 relativ zu einer durch das Zentrum der Nadel 14 verlaufenden, vertikalen Positionierachse zu erkennen und daraus ein Korrektursignal bzw. Korrektursignale abzuleiten.

In den Fig. 3-5 sind schematisch verschiedene Lagen eines Bauelementes 9 in Bezug auf die Positionierachse P innerhalb der rahmenförmigen Lageerfassungs-Einrichtung 15 dargestellt. Während das Bauelement 9 gemäss Fig. 3 die theoretisch korrekte Sollposition in X- und Y-Richtung einnimmt und auch nicht relativ zum Rahmen der Einrichtung 15 verdreht ist, befindet sich das Bauelement gemäss Fig. 4 und 5 in verdrehter bzw. dezentrierter Lage.

Die Lageerfassungs-Einrichtung 15 ist im Stande, im Fall der Situation gemäss Figur 4 den Drehwinkel des Bauelementes 9 zu erkennen, daraus ein Korrektursignal abzuleiten und die Nadel 14 bzw. das Bauteiletragorgan 13 zu einer Drehung zu veranlassen, bis das Bauelement 9 die in Figur 3 gezeigte Lage einnimmt. Andererseits wird durch die Einrichtung 15 eine laterale Verschiebung in horizontaler Richtung, in der Situation gemäss Figur 5 um den Betrag x in X-Richtung und um den Betrag y in Y-Richtung, erkannt. Daraus werden ebenfalls Korrektursignale abgeleitet, die entweder die Bewegungsbahn der Anordnung 11 in Richtung der Pfeile A und B oder die Verschiebung des Arbeitstisches 2 in X- und Y-Richtung oder aber eine Kombination davon beeinflussen.

Der praktische Ablauf des Verfahrens ist wie folgt: Die Bauteile-Transportvorrichtung 11 befindet gemäss Figur 1 in einer Position oberhalb eines ausgewählten Magazins 6. Die Nadel 14 wird in Richtung des Pfeiles C abgesenkt, bis deren Spitze auf der Oberfläche des aufzunehmenden Bauelementes 9c auftrifft. Danach wird die Vakuumquelle angelegt und die Nadel 14 zurückgezogen, so dass das Bauelement 9c an der Spitze der Nadel 14 haften bleibt. Im Normalfall wird ein so aufgenommenes Bauelement 9c nicht genau zentrisch an der Spitze der Nadel 14 haften, sondern in X- und Y-Richtung versetzt sein. Ferner ist es auch möglich, das das Bauteil verdreht ist.

Nun bewegt sich die Transportvorrichtung 11 in die in Figur 1 gestrichelt gezeigte Lage über dem Arbeitstisch 2 und die Nadel 14 wird soweit abgesenkt, dass sich das Bauelement 9c innerhalb der rahmenförmigen Lageerfassungs-Einrichtung 15 befindet. Dort wird die Exzentrizität der Lage des Bauelementes 9c gegenüber der theoretischen Positionierachse im Zentrum der Nadel 14 erfasst ; ein daraus resultierendes Korrektursignal bewirkt nun entweder eine Lagekorrektur der Transportvorrichtung 11 in Richtung der Pfeile A und/oder B, eine Verschiebung des Arbeitstisches 2 in X- und/oder Y-Richtung oder eine Kombination beider Korrekturbewegungen. Nachdem dies geschehen ist, ist sichergestellt, dass sich das an der Spitze der Nadel 14 befindliche Bauelement 9c in korrekter Lage oberhalb des Werkstückes 3 befindet, so dass anschliessend die Nadel 14 abgesenkt werden kann, um das Bauelement 9c mit höchster Präzision auf das Werkstück 3 abzulegen.

Wie schon zuvor erwähnt, erkennt die Lageerfassungs-Einrichtung 15 eine Verdrehung des Bauelementes 9c gegenüber der theoretischen Sollage. Das daraus gewonnene Korrektursignal kann dazu benützt werden, die Nadel 14 zu verdrehen, bis die erwünschte, parallele Ausrichtung des Bauelementes 9c erreicht ist. Mit Hilfe der heute zur Verfügung stehenden Steuerorgane kann diese Auswertung und Korrektur so schnell erfolgen, dass kein nennenswert langer Aufenthalt des Bauelementes in der Lageerfassungs-Einrichtung 15 erforderlich ist.

Nachdem das Bauelement 9c auf dem Werkstück 3 abgelegt worden ist, wird das Vakuum innerhalb der Nadel 14 aufgehoben und diese zurückgezogen, währenddem sich die Transportvorrichtung 11 in die in Figur 1 gezeigte Ausgangslage oder in eine in Richtung des Pfeiles A etwas verschobene Lage über einem der Magazine 6 zurückbewegt. Nun kann die Nadel 14 erneut abgesenkt werden, um ein weiteres Bauelement 9a-9b aufzunehmen, und der vorstehend geschilderte Vorgang wiederholt sich von Neuem.

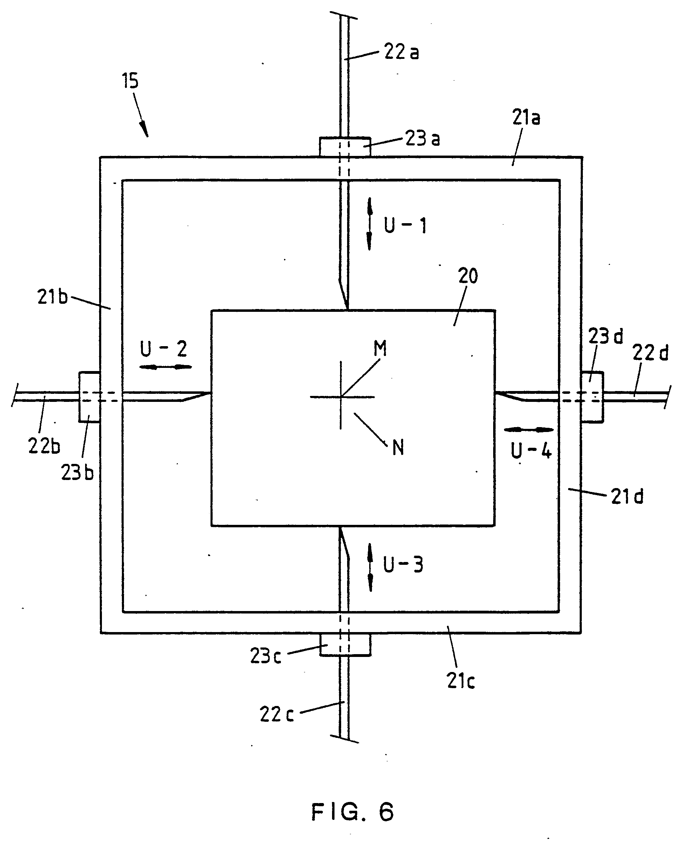

Nachstehend soll nun etwas näher auf verschiedene Ausführungsvarianten der Vorrichtung zur Durchführung des Verfahrens eingegangen werden, dies insbesondere auch im Zusammenhang mit den Darstellungen gemäss Fig. 6 bis 11.

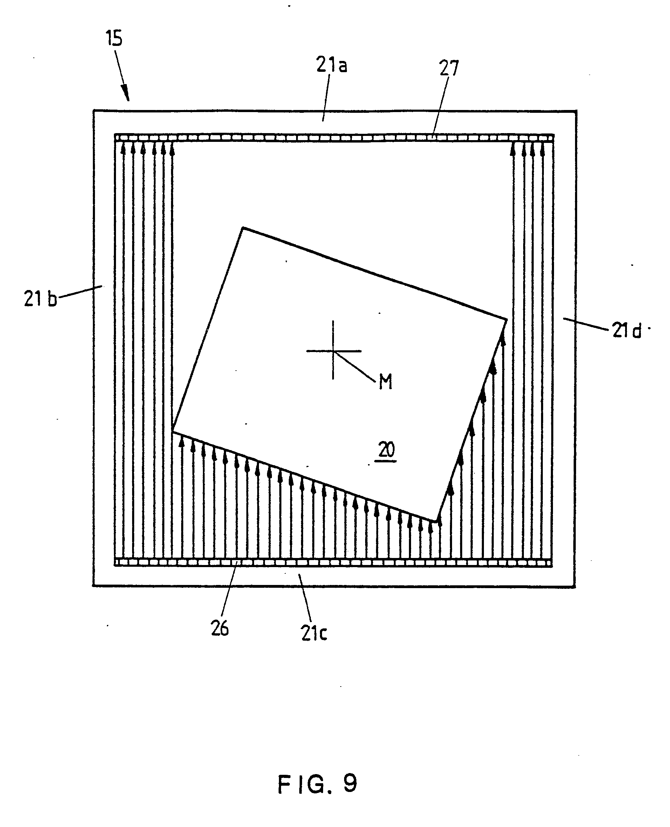

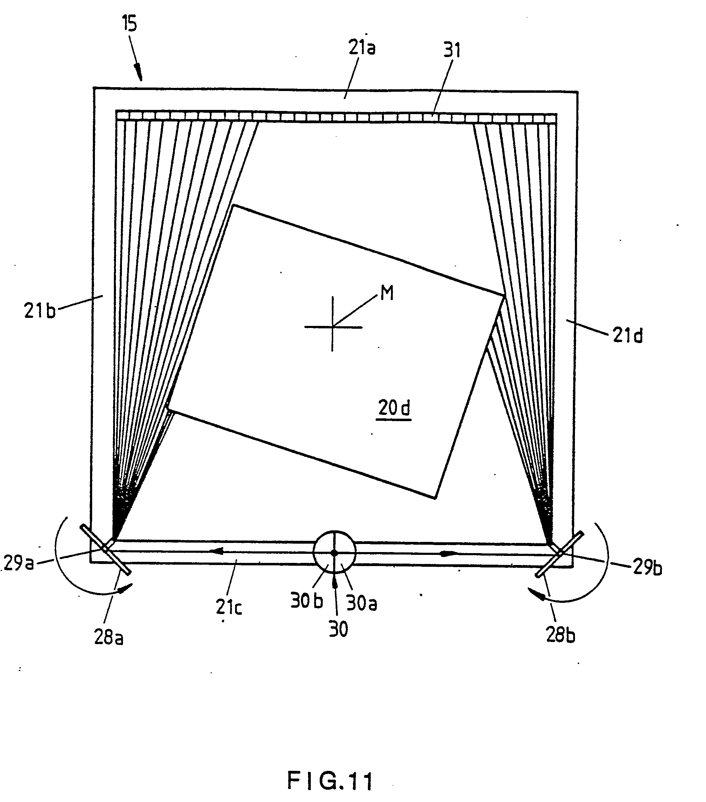

Das Bauelement gemäss Fig. 9 und 11 befindet sich in verdrehter bzw. dezentrierter Lage, während das Bauelement gemäss Fig. 6, 7, 8 und 10 lediglich in X- bzw. Y-Richtung verschoben ist. Die Lageerfassungs-Einrichtung 15 ist im Stande, im Fall der Situation gemäss Fig. 9 und 11 den Drehwinkel des Bauelementes 9 zu erkennen, daraus ein Korrektursignal abzuleiten und die Nadel 14 bzw. das Tragoran 13 zu einer Verdrehung zu veranlssen, bis das Werkstück 9 die in Fig. 6, 7, 8 und 10 gezeigte Lage parallel zu den Seitenkanten des Werkstückes 3 einnimmt. Andererseits wird durch die Einrichtung 15 eine laterale Verschiebung in horizontaler Richtung, in der Situation z. B. gemäss Figur 6 um den Betrag x in X-Richtung und um den Betrag y in Y-Richtung, erkannt. Daraus werden ebenfalls Korrektursignale abgeleitet, die entweder die Bewegungsbahn der Anordnung 11 in Richtung der Pfeile A und B oder die Verschiebung des Arbeitstisches 2 in X und Y-Richtung oder aber eine Kombination all dieser Bewegungen beeinflussen, auch möglich, dass das Bauelement zudem verdreht sein kann.

Verschiedene Ausführungsbeispiele der Lageerfassungs-Einrichtung 15 sind in den Fig. 6 bis 11 dargestellt und werden im folgenden näher erläutert.

In der Figur 6 ist eine mechanische Lösung zu sehen, die mit einer berührenden Abtastung des zu positionierenden Bauelementes 20 arbeitet. Die Einrichtung 15 umfasst einen quadratischen Rahmen, der aus vier Seitenteilen 21a-21d zusammengesetzt ist. Jedes der Rahmenteile 21a-21d trägt eine Nadel 22a-22d, die längsverschiebbar gelagert ist und unter Einfluss eines Antriebs- und Messorganes 23a-23d steht. Mittels letzterem können die Nadeln 22a-22d in Richtung der Pfeile U-1-U-4 längsverschoben werden, d. h. quer zum Verlauf der Rahmenseiten 21a-21d. Die Ausbildung der Antriebs- und Messorgane 23a-23d ist bekannter Stand der Technik und braucht an dieser Stelle nicht näher erläutert zu werden. Jedenfalls stehen die Organe 23a-23d in Wirkungsverbindung mit dem zentralen Steuerorgan der gesamten Einrichtung, wobei die Funktion wie folgt ist :

In der Ausgangslage befinden sich die Nadeln 22a-22d in einer mehr oder weniger zurückgezogenen Position, so dass ein von der Hohlnadel 14 getragenes Bauelement 20 in das Innere des Rahmens 21a-21d eintauchen kann. Das Zentrum der Nadel 14, d. h. die theoretische Positionierachse, ist mit M bezeichnet. Nachdem das Bauelement 20 in die Lageerfassungs-Einrichtung 15 eingetaucht ist, werden die Nadeln 21a-21d unter Wirkung der Antriebs- und Messorgane 23a-23d in Richtung des Bauelementes 20 bewegt, bis die Nadelspitzen auf den Seitenflächen des desselben aufliegen. Der Verschiebeweg der Nadeln 22a-22d wird dabei von den Antriebs- und Messorganen 23a-23d erfasst ; aus diesen Messwerten kann ein Korrektursignal bzw. können Korrektursignale gebildet werden, die ein Mass für die Abweichung des Zentrums N des Bauelementes 20 von der theoretischen Sollposition, nämlich der Achse M bilden. Mit diesem Korrektursignal wird der Antrieb der Bauelemente-Transportvorrichtung und/oder der Antrieb der Werkstück-Halteanordnung beeinflusst. Nachdem die Lage des Bauelementes 20 erkannt ist, werden die Nadeln 22a-22d zurückgezogen und das Bauelement 20 kann auf das Werkstück 3 abgesenkt werden, wo es die theoretisch optimale Position mit grösstmöglichster Präzision einnimmt. Die in der Figur 3 dargestellte und vorstehend beschriebene Anordnung der Lageerfassungs-Einrichtung 15 ist insbesondere dann vorteilhaft anzuwenden, wenn die Beschaffenheit der Seitenflächen der Bauelemente 20 unregelmässig oder nicht im voraus bekannt ist. Andererseits ist ein Nachteil dieser Anordnung darin zu erblicken, dass eine Verschwenkung des Bauelementes 20 um die Achse M nicht erkannt werden kann. Es muss also vorausgesetzt werden, dass das Bauelement 20 in einer winkelgerechten Position aus dem Magazin entnommen worden ist und lediglich in X- und Y-Richtung gegenüber der Soll-Lage bezüglich der Achse M verschoben ist.

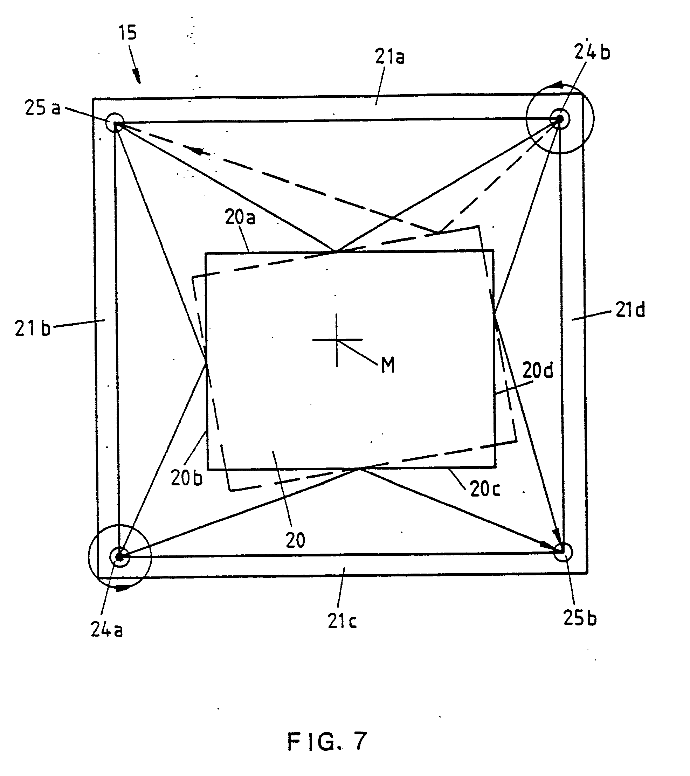

Ein zweites Ausführungsbeispiel der Lageerfassungs-Einrichtung 15 ist in der Figur 7 dargestellt. Es ist wiederum ein quadratischer Rahmen mit vier Rahmenseiten 21a-21d vorhanden, in welchen das mit dem Bauelement 20 versehene Greiforgan der Bauelement-Haltevorrichtung eintaucht. Die Anordnung gemäss Fig. 4 umfasst zwei laserdioden 24a und 24b, die drehbar an einander gegenüberliegenden Ecken des Rahmen angeordnet sind. Die Laserdioden senden einen scharf gebündelten Strahl aus, der von einem innerhalb des Rahmens befindlichen Bauteil reflektiert wird. Die zwei verbleibenden, ebenfalls gegenüberliegenden Ecken des Rahmens nehmen je eine Empfangsdiode 25a und 25b aus, die einen reflektierten Strahl zu empfangen bestimmt sind.

Aus der Fig. 7 ist zu entnehmen, dass die Laserdiode 24b im Verlauf ihrer Rotation einmal einen Strahl aussenden wird, der zunächst von der Seitenfläche 20a des Bauelementes 20 so reflektiert wird, dass er auf die Empfangsdiode 25a fällt und von dieser registriert wird. Im Verlauf der weiteren Rotation der Laserdiode 24b tritt der Zustand ein, bei dem der Laserstrahl von der Seitenfläche 20d des Bauelementes reflektiert und von der Empfangsdiode 25b aufgenommen wird. Im Moment des Empfangs des einerseits von der Seitenfläche 20a und andererseits von der Seitenfläche 20d reflektiertern Laserstrahls nimmt die Laserdiode 24b jeweils eine ganz bestimmte Winkelstellung ein. Diese wird vom Steuergerät der Einrichtung erkannt und gespeichert. Entsprechendes gilt für die rotierende Laserdiode 24a : Sie wird im Verlauf ihrer Rotation eine Winkelstellung einnehmen, bei der der ausgehende Strahl von der Seitenfläche 20c so reflektiert wird, dass er von der Empfangsdiode 25b empfangen wird, und danach eine solche Winkelstellung, dass der Strahl von der Seitenfläche 20b des Bauelementes so reflektiert wird, dass er auf die Empfangsdiode 25a fällt. Auch diese beiden Winkelstellungen werden vom Steuergerät der Einrichtung registriert. Aus den im Steuergerät registrierten Winkelwerten lässt sich, nach bekannten mathematischen Gesetzen, ein Korrektursignal bzw. mehrere Korrektursignale ableiten, das bzw. die ein Mass für die Abweichung der Lage des Bauelementes 20 von der theoretisch idealen Soll-Lage ist bzw. sind. Die vorstehend geschilderten Überlegungen gehen dabei davon aus, dass das Bauelement 20 gegenüber den Rahmenseiten 21a-21d eine winkelgerechte Lage einnimmt ; dies ist in Fig. 7 mit ausgezogenen Linien dargestellt. Es kann aber auch der Fall eintreten, dass das Bauelement 20 eine um die Achse M verdrehte Position einnimmt. Diese Position, wie auch die Reflexionsverhältnisse der Laserstrahlen, sind in einem solchen Fall in Fig. 7 gestrichelt dargestellt. Es leuchtet ein, dass somit die Verdrehwinkel der Laserdioden 24a und 24b im Moment, wo deren Strahlen von den Empfangsdioden 25a und 25b erfasst werden, gegenüber der vorherigen Situation verschieden sind. Durch Auswertung der Winkelstellungen der beiden Laserdioden, bei denen eine Reflexion eintritt, und durch kontinuierliches Verdrehen des Bauelementes 20, gegebenenfalls in beiden Richtungen nacheinander, lässt sich nach ebenfalls bekannten mathematischen Gesetzen diejenige Position des Bauelementes bestimmen, in der es eine genau parallele Lage zu den Seiten 21a-21d des Rahmens einnimmt.

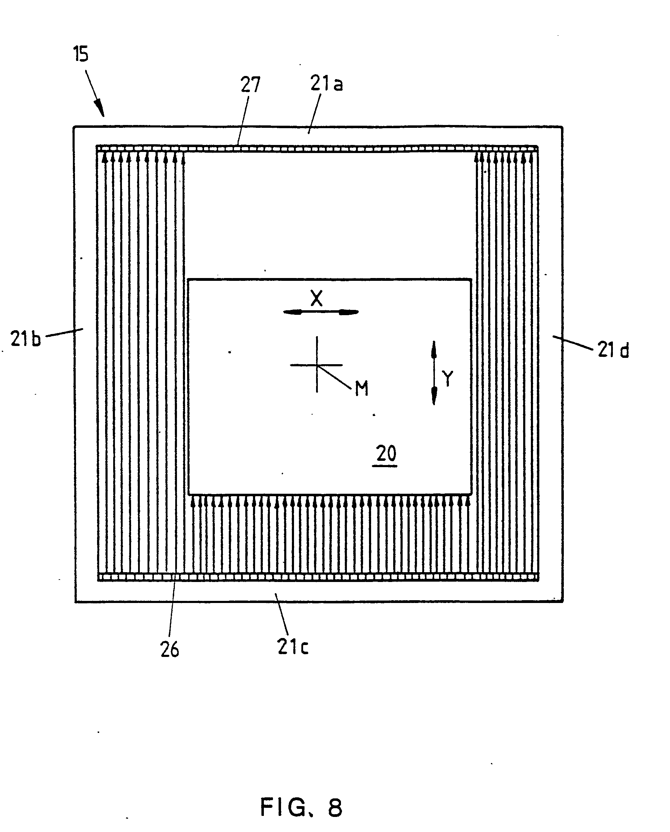

In den Figuren 8 und 9 ist ein weiteres Ausführungsbeispiel der Lageerfassungs-Einrichtung 15 dargestellt, das ebenfalls mit berührungsloser Abtastung des Bauelementes 20 arbeitet. Die eine Rahmenseite 21c ist dabei mit einer Reihe von Strahlen aussendenden Elementen 26, z. B. mit Laserdioden ausgestattet. Deren Strahl ist scharf gebündelt und verläuft parallel zu den Rahmenseiten 21b und 21d. Auf der der Rahmenseite 21c gegenüberliegenden Rahmenseite 21a ist eine entsprechend angeordnete Reihe von Empfangselementen 27, z. B. von lichtempfindlichen Dioden oder ähnlichen Halbleitern vorgesehen, in der Weise, dass jede der Laserdioden 26 einen Strahl auf eine zugeordnete Empfangsdiode 27 richtet.

Bei der Situation gemäss Figur 8 ist das Bauelement 20 gegenüber der Zentrierachse M in X-Richtung nach rechts und in Y-Richtung nach unten verschoben, nimmt jedoch eine winkelgerechte, d. h. zu den Seiten 21 des Rahmens parallele Lage ein. Demzufolge empfangen eine Anzahl von linksseitigen Dioden 27 sowie eine Anzahl von rechtsseitigen Dioden 27 die von den Laserdioden 26 ausgesandten Strahlen, währenddem die mittig gelegenen Empfangsdioden 27 keinen Strahl empfangen können, da sie im Schatten des Bauelementes 20 liegen. Das Verhältnis zwischen der Anzahl der linksseitigen und der rechtseitigen Empfangsdioden 27, die einen Strahl empfangen, bildet somit ein Mass für die Exzentrizität der Lage des Bauelementes 20 in X-Richtung. Zur Erfassung der Exzentrizität in Y-Richtung wird das Bauelement 20 um exakt 90 grad verdreht ; in entsprechender Weise kann ein Mass für die Lageabweichung gewonnen werden. Diese beiden Messwerte werden im Steuergerät der Einrichtung verarbeitet, so dass ein bzw. mehrere Korrektursignale resultieren, die die Bewegung der Bauelemente-Transportvorrichtung und/oder der Werkstück-Haltevorrichtung beeinflussen.

Falls die Situation der Figur 9 vorliegt, d. h. falls das Bauelement 20 gegenüber der Achse M verdreht ist, empfängt nur eine geringere Anzahl der rechtsseitig sowie der linksseitig gelegenen Empfangsdioden 27 einen von den Laserdioden 26 ausgehenden Strahl. Somit wird das Bauelement 20 solange um die Achse M verdreht, bis die Anzahl der einen Strahl empfangenden Dioden 27 maximal ist. Dadurch ist sichergestellt, dass das Bauelement 20 relativ zu den Rahmenseiten 21 eine parallele Lage einnimmt.

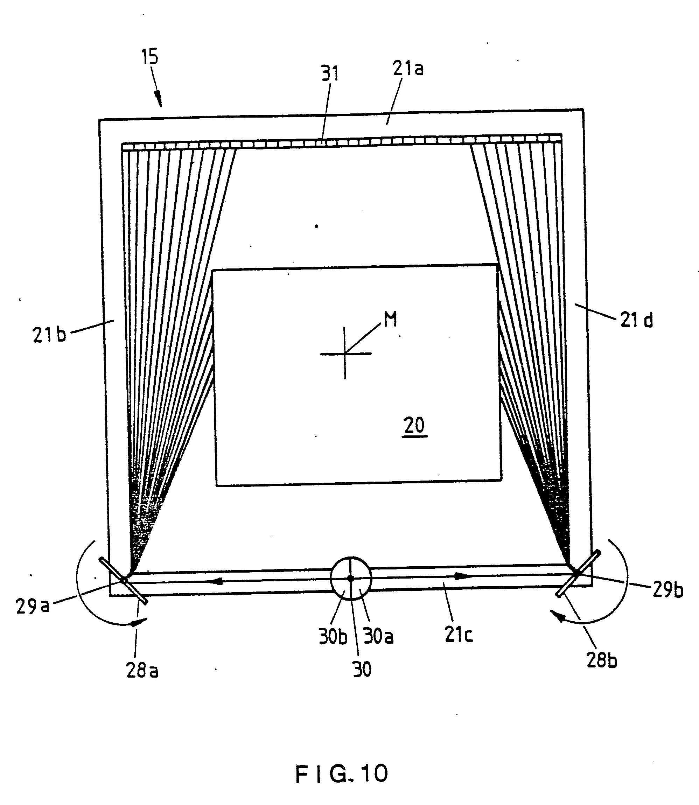

Eine weitere Ausführungsmöglichkeit, die ebenfalls berührungslos arbeitet und die im wesentlichen eine Kombination der Ausführungen gemäss Figur 7 einerseits und gemäss Figuren 8 und 9 anderseits darstellt, ist in den Figuren 10 und 11 zu sehen. Die Lageerfassungs-Einrichtung 15 umfasst wiederum einen Rahmen mit den Seiten 21a-21d, wobei die eine Seite 21a ähnlich wie bei der Ausführung gemäss Figuren 8 und 9 mit einer Reihe von Empfangsdioden 31 versehen ist. Die gegenüberliegende Seite 21c umfasst eine fest angebrachte Lichtquelle 30 in Form einer doppelten Laserdiode, deren Hälften 30a und 30b einen eng gebündelten Strahl in zwei diametral gegenüberliegende Richtungen aussenden. Die Strahlen verlaufen im wesentlichen parallel zur Rahmenseite 21c. Im Bereich der zur Rahmenseite 21c benachbart liegenden Ecken sind Reflexionselemente 28a und 28b, z. B. in Form von Spiegeln angebracht, die um eine Achse 29a bzw. 29b rotierbar sind. Die von den Hälften 30a und 30b der Laserdiode 30 ausgehenden Strahlen treffen auf die Spiegel 28a und 28b auf und werden gegen das Innere der Lageerfassungs-Einrichtung 15 reflektiert, wo sich das Bauelement 20 befindet.

Je nach Lage des Bauelementes 20, sei es in X- und Y-Richtung, sei es bezüglich einer Verdrehung um die Achse M, wie es in der Figur 11 zu sehen ist, werden mehr oder weniger der Empfangsdioden 31 von den durch die Laserdioden 30a und 30b ausgesandten und von den rotierenden Spiegeln 28a und 28b reflektierten Lichtstrahlen beaufschlagt. Das zweckmässigste Vorgehen wird wieder wie folgt sein : Das Bauelement 20, das sich in einer Lage gemäss Figur 11 befinden mag, wird solange um die Achse M verschwenkt, bis dessen winkelgerechte Lage erkannt ist. Danach wird aus der Anzahl der linksseitig und der rechtseitig vom Lichtstrahl beaufschlagten Empfangsdioden innerhalb der Diodenzeile 31 auf eine allfällige Verschiebung in X-Richtung geschlossen und daraus ein X-Korrektursignal abgeleitet. Nun wird das Bauelement 20 um exakt 90 grad gedreht, eine allfällige Y-Abweichung wird erfasst und daraus ein Y-Korrektursignal gewonnen. Diese Korrektursignale werden, wie schon zuvor erwähnt, vom zentralen Steuergerät in dem Sinne verarbeitet, dass dadurch eine Nachregelung der Bewegung der Bauteile-Transportvorrichtung und/oder der Werkstück-Halteanordnung resultiert.

Es versteht sich von selbst, dass die beispielsweise beschriebenen Vorrichtungen und Anordnungen im Rahmen der Erfindung zahlreichen Modifikationen unterworfen sein können ; sinngemäss gilt das gleiche für das Verfahren. Des weiteren ist es denkbar, die erfindungsgemässe Einrichtung nicht nur zur Positionierung von Bauelementen auf einem Leiterträger für elektronische Schaltungen zu verwenden, sondern bei jeglichem anderen Arbeitsvorgang, der die genaue Positionierung eines Bauteiles an einer vorgegebenen Position auf bzw. in einem Werkstück erfordert.

## Patentansprüche

1. Verfahren zur Positionierung von Bauteilen auf einem Werkstück, bei welchem ein Bauteil aus einem Magazin bzw. aus einem ausgewählten Magazin einer Magazingruppe entnommen, dessen Lage abgetastet, unter Berücksichtigung der ermittelten Lage mit Hilfe eines Bauteile-Transportorgans in den Bereich des Werkstückes transportiert und in einer vorgegebenen Position auf das Werkstück aufgebracht wird, dadurch gekennzeichnet, dass das Werkstück und/oder das Bauteile-Transportorgan während, bzw. im Falle des Bauteile-Transportorganes nur nach dem Entnehmen des Bauteiles, in eine relative Sollposition bewegt wird bzw. werden, in der eine Positionierachse des Bauteile-Transportorganes mit der Sollposition des Bauteiles auf dem Werkstück übereinstimmt, dass anschliessend während des Transports des Bauteiles entlang seinem Bewegungspfad zum Werkstück hin, oberhalb desselben, die Ist-Lage des Bauteiles gegenüber dieser Positionierachse gemessen und eine allfällig Abweichung gegenüber der Soll-Lage ermittelt wird, dass aus der Lageabweichungs-Messung ein Korrektursignal abgeleitet wird, und dass schliesslich die Position des Werkstückes und/oder der Verschiebeweg des Bauteile-Transportorganes in Abhängigkeit vom abgeleiteten Korrektursignal korrigiert wird, bevor das Bauteil auf das Werkstück aufgebracht wird.

2. Verfahren nach Anspruch 1, dadurch gekennzeichnet, dass die Positionierachse in vertikaler Richtung verläuft und eine Lageabweichung des Bauteiles gegenüber der Positionierachse in mindestens einer horizontal verlaufenden Richtung gemessen bzw. ermittelt wird.

3. Verfahren nach Anspruch 2, dadurch gekennzeichnet, dass eine Lageabweichung des Bauteiles gegenüber der Positionierachse in zwei senkrecht zueinander verlaufenden, horizontalen Richtungen gemessen bzw. ermittelt wird.

4. Verfahren nach Anspruch 1 oder 2, dadurch gekennzeichnet, dass eine Lageabweichung des Bauteiles in Bezug auf eine Verdrehung gegenüber der Positionierachse gemessen bzw. ermittelt wird.

5. Vorrichtung zur Durchführung des Verfahrens nach einem oder mehreren der vorangehenden Ansprüche, welche Vorrichtung zumindest ein Bauteile-Magazin bzw. eine Bauteile-Magazingruppe, zumindest eine Bauteile-Transportvorrichtung mit einem Greiforgan zur Aufnahme eines Bauteiles sowie zumindest eine Werkstück-Halteanordnung zur Aufnahme mindestens eines Werkstückes umfasst, wobei die Bauteile-Transportvorrichtung zwischen dem Bauteile-Magazin bzw. der Bauteile-Magazingruppe und der Werkstück-Halteanordnung verschiebbar gelagert ist und wobei eine Lageerfassungs-Einrichtung zur Abtastung der momentanen Lage des zu transportierenden Bauteiles vorgesehen ist, dadurch gekennzeichnet, dass die Lageerfassungs-Einrichtung (15) im Bewegungspfad eines vom Greiforgan (13, 14) der Bauteile-Transportvorrichtung (10, 11) getragenen Bauteiles (9, 20) angeordnet ist und die relative Lageabweichung dieses Bauteiles (9, 20), im Abstand oberhalb der Werkstück-Halteanordnung (1, 2, 4) gegenüber einer auf eine Positionierachse durch das Greiforgan bezogenen Soll-Position misst, und dass ein mit der Lageerfassungs-Einrichtung (15) und zumindest mit dem Antrieb der Bauteile-Transportvorrichtung (10, 11) verbundenes Steuergerät vorgesehen ist, welches den genannten Antrieb unter Berücksichtigung des Lageabweichungs-Messwertes beeinflusst.

6. Vorrichtung nach Anspruch 5, dadurch gekennzeichnet, dass die Lageerfassungs-Einrichtung (15) an der Bauteile-Transportvorrichtung (11), unterhalb des Greiforganes (13, 14), angeordnet ist.

7. Vorrichtung nach einem der Ansprüche 5 oder 6, dadurch gekennzeichnet, dass die Lageerfassungs-Einrichtung (15) einen Rahmen (21a-21d) aufweist, durch welchen das mit dem Bauteil (20) versehene Greiforgan (13, 14) der Bauteile-Transportvorrichtung hindurchbewegbar ist.

8. Vorrichtung nach einem der Ansprüche 5 bis 7, dadurch gekennzeichnet, dass der Rahmen (21a-21d) rechteckige bzw. quadratische Gestalt besitzt und entlang mindestens einer Rahmenseite (21a bzw. 21b bzw. 21c bzw. 21d) mit Lageerfassungs-Organen (22a-22d ; 23a-23d bzw. 24a, b ; 25a, b bzw. 26 ; 27 bzw. 30 ; 31) versehen ist.

9. Vorrichtung nach einem der Ansprüche 5 bis 8, dadurch gekennzeichnet, dass zumindest einzelne der Rahmenseiten (21a-21d) mit einer längsverschiebbaren, sich im wesentlichen senkrecht zur Rahmenseite erstreckenden, zumindest annähernd in der Mitte der Rahmenseite angeordneten Lageerfassungs-Nadel (22a-22d) versehen sind, die unter Einfluss eines Antriebs- und Messorganes (23a-23d) stehen, welches die Nadel gegen die Mitte des Rahmens zu verschieben bestimmt ist und welche das Mass der Verschiebung der Nadel misst.

10. Vorrichtung nach Anspruch 9, dadurch gekennzeichnet, dass die Antriebs- und Messorgane (23a-23d) mit dem Steuergerät der Einrichtung in Wirkungsverbindung stehen.

11. Vorrichtung nach einem der Ansprüche 5 bis 8, dadurch gekennzeichnet, dass im Bereich zweier gegenüberliegender Ecken des Rahmens je ein zu einer zumindest um 90° verschwenkbaren Bewegung antreibbares, einen durch das Bauteil (20) reflektierbaren Strahl aussendendes Element (24a, 24b) und im Bereich der beiden anderen, gegenüberliegenden Ecken des Rahmens je ein den genannten Strahl empfangendes Element (25a, 25b) vorgesehen ist.

12. Vorrichtung nach Anspruch 11, dadurch gekennzeichnet, dass die die Strahlen aussendenden Elemente (24a, 24b) um 360° rotierbar sind.

13. Vorrichtung nach den Ansprüchen 11 oder 12, dadurch gekennzeichnet, dass die die Strahlen aussendenden Elemente (24a, 24b) sowie die die Strahlen empfangenden Elemente (25a, 25b) an das Steuergerät der Einrichtung angeschlossen sind.

14. Vorrichtung nach einem der Ansprüche 11 bis 13, dadurch gekennzeichnet, dass die die Strahlen aussendenden Elemente (24a, 24b) Laserdioden und die die Strahlen empfangenden Elemente (25a, 25b) lichtempfindliche Halbleiterelemente sind.

15. Vorrichtung nach einem der Ansprüche 5 bis 8, dadurch gekennzeichnet, dass zumindest entlang einer Rahmenseite (21c) eine Reihe von nebeneinander angeordneten, Strahlen aussendenden Elementen (26) und zumindest entlang einer gegenüber dieser Rahmenseite liegenden Rahmenseite (21a) eine Reihe von nebeneinander angeordneten, die genannten Strahlen empfangenden Elementen (27) vorgesehen sind.

16. Vorrichtung nach Anspruch 15, dadurch gekennzeichnet, dass die die Strahlen aussendenden Elemente (26) Laserdioden und die die Strahlen empfangenden Elemente (27) lichtempfindliche Halbleiterelemente sind, wobei jeder Laserdiode ein lichtempfindliches Halbleiterelement zugeordnet ist.

17. Vorrichtung nach einem der Ansprüche 5 bis 8, dadurch gekennzeichnet, dass entlang mindestens einer Rahmenseite (21a) eine Reihe von nebeneinander angeordneten, lichtempfindlichen Empfangselementen (31) vorgesehen ist, und dass in der Mitte der gegenüberliegenden Rahmenseite (21c) ein nach zwei diametral gegenüberliegenden Seiten Strahlen aussendendes Element (30) sowie im Bereich der Enden dieser Rahmenseite (21c) zwei zu einer rotierenden Bewegung antreibbare Reflexionselemente (28a, 28b) angeordnet ist bzw. sind.

18. Vorrichtung nach Anspruch 17, dadurch gekennzeichnet, dass das genannte, Strahlen aussendende Element (30) eine Doppel-Laserdiode ist, welche je einen Laserstrahl in einer im wesentlichen parallel zu dieser Rahmeseite (21c) verlaufenden Richtung zu den beiden als Spiegel (28a, 28b) ausgebildeten Reflexionselementen aussendet.

19. Vorrichtung nach Anspruch 17 oder 18, dadurch gekennzeichnet, dass die lichtempfindlichen Empfangselemente (31) durch Halbleiterelemente gebildet sind.

20. Vorrichtung nach einem oder mehreren der Ansprüche 11 bis 19, dadurch gekennzeichnet, dass die die Strahlen aussendenden Elemente (24a, b bzw. 26 bzw. 30) sowie die die Strahlen empfangenden Elemente (25a, b bzw. 27 bzw. 31) mit dem Steuergerät der Einrichtung in Wirkungsverbindung stehen.

**Claims**

1. Method for positioning components on a workpiece, wherein a component is removed from a magazine or storage bin, or from one selected magazine or storage bin from a group of magazines or bins, its position is scanned and recorded, the component is transported into the region of the workpiece, using a component transporting means and taking the component's recorded position into consideration, and placed in a preselected position onto the workpiece, characterized in that the workpiece and/or the component transporting means is/are moved into a relative nominal position in which a positioning axis of the component transporting means coincides with the nominal position of the component on the workpiece, while the component is being removed, or in the case of moving the component transporting means only after removing the component, that thereafter, in the course of transporting the component along its route towards the workpiece, the actual position of the component is measured with reference to said positioning axis while it is above the workpiece and any deviation from the nominal position that occurs is recorded, that a correction signal is derived from the measured deviation in position, and that finally the position of the workpiece and/or the displacement path of the component transporting means is corrected as a function of the derived correction signal before the component is placed on to the workpiece.

2. Method according to Claim 1, characterized in that the positioning axis extends in the vertical direction and any deviation in the position of the component relative to the positioning axis is scanned and recorded in at least one direction within a horizontal plane.

3. Method according to Claim 2, characterized in that any deviation in the position of the component relative to the positioning axis is scanned and recorded in two directions, perpendicular to one another, within a horizontal plane.

4. Method according to Claim 1 or 2, characterized in that any deviation in the position of the component with regard to a rotation relative to the positioning axis is scanned and recorded.

5. Apparatus for carrying out the method according to one or more of the preceding Claims, said apparatus comprising at least one component magazine or storage bin, or a group of component magazines or storage bins, at least one component transporting apparatus having a pick-up member for gripping the component, and at least one workpiece mounting assembly for receiving at least one workpiece, said component transporting apparatus being displaceably mounted between the component magazine or storage bin, or group thereof, and the workpiece mounting assembly, and a position detecting device being provided for scanning the current position of the component being transported, characterized in that the position detecting device (15) is disposed in the path along which a component (9, 20) carried by the pick-up member (13, 14) of the component transporting apparatus (10, 11) is moved and that it scans the relative deviation in position of said component (9, 20), while spaced above the workpiece mounting assembly (1, 2, 4) relative to a nominal position based on a positioning axis running through the pick-up member, and that there is provided a control apparatus connected to the position detecting device (15) and at least to the drive of the component transporting apparatus (10, 11), said control apparatus influencing said drive in response to the scanned deviation in position.

6. Apparatus according to Claim 5, characterized in that the position detecting device (15) is located on the component transporting apparatus (11) below the pick-up member (13, 14).

7. Apparatus according to either of Claims 5 or 6, characterized in that the position detecting device (15) has a frame (21a-21d) through which the pick-up member (13, 14) of the component transporting apparatus equipped with the component (20) passes.

8. Apparatus according to any of Claims 5 to 7, characterized in that the frame (21a-21d) is rectangular or square in shape and is provided with position detecting means (22a-22d ; 23a-23d or 24a,b ; 25a,b or 26 ; 27 or 30 ; 31) along at least one frame side (21a or 21b or 21c or 21d, respectively).

9. Apparatus according to any of Claims 5 to 8, characterized in that at least certain of the frame sides (21a-21d) are provided with a position detection needle (22a-22d) which is longitudinally displaceable, extends substantially perpendicular to the frame side, and is arranged at least approximately in the center of the frame side, and which is operatively connected to a driving and measuring means (23a-23d) designed to displace the needle towards the center of the frame, and which measures the extent to which the needle is displaced.

10. Apparatus according to Claim 9, characterized in that the driving and measuring means (23a-23d) are operatively connected to the control apparatus of the system.

11. Apparatus according to any of Claims 5 to 8, characterized in that in the region of two opposing corners of the frame there is respectively provided an element (24a, 24b) adapted to be driven to a movement that can be swivelled by at least 90° and emitting a beam which the component (20) is able to reflect, and in the region of the other two opposing corners of the frame there is respectively provided an element (25a, 25b) which receives said beam.

12. Apparatus according to Claim 11, characterized in that the elements (24a, 24b) emitting the beams are rotatable by 360°.

13. Apparatus according to Claim 11 or 12, characterized in that the elements (24a, 24b) emitting the beams and the elements (25a, 25b) receiving the beams are connected to the control apparatus of the system.

14. Apparatus according to any of Claims 11 to 13, characterized in that the elements (24a, 24b) emitting the beams are laser diodes and the elements (25a, 25b) receiving the beams are light-sensitive semiconductor elements.

15. Apparatus according to any of Claims 5 to 8, characterized in that a row of adjacent, beam-emitting elements (26) is provided along at least one frame side (21c) and a row of adjacent elements (27) receiving said beams is provided along at least one frame side (21a) situated opposite said frame side (21c).

16. Apparatus according to Claim 15, characterized in that the elements (26) emitting the beams are laser diodes and the elements (27) receiving the beams are light-sensitive semiconductor elements, one light-sensitive semiconductor element being associated with each laser diode.

17. Apparatus according to any of Claims 5 to 8, characterized in that a row of adjacent light-sensitive receiver elements (31) is provided along at least one frame side (21a), and that an element (30) emitting beams in the direction of two diametrically opposite sides is disposed in the center of the opposite frame side (21c) and two reflector elements (28a, 28b) adapted to be driven to a rotating movement are disposed in the region of the ends of said frame side (21c).

18. Apparatus according to Claim 17, characterized in that said element (30) emitting beams is a double laser diode which sends a laser beam to each of the two reflector elements, which are constructed as mirrors (28a, 28b), in a direction substantially parallel to said frame side (21c).

19. Apparatus according to Claim 17 or 18, characterized in that the light-sensitive receiver elements (31) are semiconductor elements.

20. Apparatus according to one or more of Claims 11 to 19, characterized in that the elements (24a,b or 26 or 30) which emit the beams and the elements (25a,b or 27 or 31, respectively) which receive the beams are operatively connected to the control apparatus of the system.

**Revendications**

1. Procédé de positionnement d'éléments sur une pièce à équiper, selon lequel on prélève un élément d'un magasin, ou d'un magasin sélectionné parmi un groupe de magasins, on détermine sa position, on le transporte dans la zone de la pièce à équiper à l'aide d'un organe de transport d'élément en tenant compte de la position déterminée et on le pose sur la pièce à équiper dans une position présélectionnée, caractérisé en ce qu'on déplace la pièce et/ou l'organe de transport, pendant le prélèvement de l'élément ou, dans le cas de l'organe de transport, seulement après ce prélèvement, de façon à lui ou leur faire adopter une position relative prescrite dans laquelle un axe de positionnement de l'organe de transport coïncide avec la position présélectionnée de l'élément sur la pièce à équiper, en ce qu'ensuite, pendant le transport de l'élément le long de la trajectoire de son déplacement jusqu'à la pièce à équiper, on procède, au-dessus de cette dernière, à la mesure de la position réelle de l'élément par rapport audit axe de positionnement et on détermine un écart éventuel par rapport à la position présélectionnée, en ce qu'on déduit de la mesure de cet écart de position un signal de correction et en ce qu'enfin, en fonction du signal de correction ainsi déduit, on corrige la position de la pièce et/ou le trajet de déplacement de l'organe de transport, avant de poser l'élément sur la pièce.

2. Procédé suivant la revendication 1, caractérisé en ce que l'axe de positionnement est orienté suivant une direction verticale et en ce que c'est suivant au moins une direction orientée horizontalement qu'on mesure ou détermine l'écart de position de la pièce par rapport à cet axe de positionnement.

3. Procédé suivant la revendication 2, caractérisé en ce que c'est suivant deux directions horizontales orientées perpendiculairement entre elles qu'on mesure ou détermine un écart de position de l'élément par rapport à l'axe de positionnement.

4. Procédé suivant la revendication 1 ou 2, caractérisé en ce qu'on mesure ou détermine un écart de position de l'élément se traduisant par un décalage en rotation par rapport à l'axe de positionnement.

5. Appareil de mise en œuvre d'un procédé suivant une ou plusieurs des revendications précédentes, du type comprenant au moins un magasin d'éléments ou un groupe de magasins d'éléments, au moins un dispositif de transport d'élément comportant un organe de préhension destiné à recevoir un élément, ainsi qu'au moins un dispositif de maintien de pièce destiné à recevoir au moins une pièce à équiper, le dispositif de transport étant monté de façon à pouvoir se déplacer suivant un mouvement de translation entre le magasin ou le groupe de magasins et cet ensemble de maintien, tandis qu'il est prévu un dispositif de détection de position destiné à déterminer la position momentanée de l'élément à transporter, caractérisé en ce que ce dispositif de détection de position (15) est situé sur la trajectoire de déplacement d'un élément (9, 20) porté par l'organe de préhension (13, 14) du dispositif de transport (10, 11) et mesure l'écart relatif de position de cet élément (9, 20), placé à une certaine distance au-dessus du dispositif de maintien (1, 2, 4) par rapport à une position présélectionnée rapportée à un axe de positionnement passant par l'organe de préhension et en ce qu'il est prévu un dispositif de commande qui est relié au dispositif de détection de position (15) et au moins à la commande de déplacement du dispositif de transport (10, 11) et qui agit sur cette commande de déplacement en tenant compte de la valeur mesurée de l'écart de position.

6. Appareil suivant la revendication 5, caractérisé en ce que le dispositif de détection de position (15) est disposé sur le dispositif de transport (11), au-dessous de l'organe de préhension (13, 14).

7. Appareil suivant l'une des revendications 5 et 6, caractérisé en ce que le dispositif de détection de position (15) comprend un cadre (21a-21d) à travers lequel peut se déplacer l'organe de préhension (13, 14) du dispositif de transport, muni de l'élément (20).

8. Appareil suivant l'une des revendications 5 à 7, caractérisé en ce que le cadre (21a-21d) possède une forme rectangulaire ou carrée et est pourvu, le long d'au moins l'un (21a ou 21b ou 21c ou 21d) de ses côtés, d'organes de détection de position (22a à 22d et 23a à 23d, ou 24a-24b et 25a-25b, ou 26 et 27, ou 30 et 31).

9. Appareil suivant l'une des revendications 5 à 8, caractérisé en ce qu'au moins quelques côtés (21a...21d) du cadre sont munis d'une aiguille de détection de position (22a...22d) déplaçable suivant sa longueur, qui s'étend de manière essentiellement perpendiculaire au côté du cadre et est disposée au moins approximativement au centre de ce côté et qui est soumise à l'influence d'un organe de commande de déplacement et de mesure (23a...23d) qui sert à déplacer cette aiguille en translation par rapport au centre du cadre et mesure la valeur de ce déplacement de l'aiguille.

10. Appareil suivant la revendication 9, caractérisé en ce que les organes de commande de déplacement et de mesure (23a...23d) sont reliés, de façon à coopérer avec lui, au dispositif de commande du dispositif de détection.

11. Appareil suivant l'une des revendications 5 à 8, caractérisé en ce qu'il est prévu, dans la zone de chacun de deux coins opposés du cadre, un élément (24a, 24b) pouvant être animé d'un mouvement oscillant de rotation d'au moins 90° et émettant un rayon pouvant être réfléchi par l'élément (20) et, dans la zone de chacun des deux autres coins opposés du cadre, un élément (25a, 25b) recevant le rayon indiqué.

12. Appareil suivant la revendication 11, caractérisé en ce que les éléments (24a, 24b) émettant les rayons peuvent être déplacés en rotation sur 360°.

13. Appareil suivant la revendication 11 ou 12, caractérisé en ce que les éléments (24a, 24b) envoyant les rayons, ainsi que les éléments (25a, 25b) recevant ces rayons sont connectés au dispositif de commande du dispositif de détection.

14. Appareil suivant l'une des revendications 11 à 13, caractérisé en ce que les éléments (24a, 24b) envoyant les rayons sont des diodes laser et les éléments (25a, 25b) recevant ces rayons, des éléments semi-conducteurs photodétecteurs.

15. Appareil suivant l'une des revendications 5 à 8, caractérisé en ce qu'il est prévu, au moins le long d'un côté (21c) du cadre, une rangée d'éléments (26) envoyant des rayons, disposés côte à côte et, au moins le long d'un côté (21a) du cadre se trouvant en face de ce premier côté, une rangée d'éléments (27) recevant les rayons indiqués, disposés côte à côte.

16. Appareil suivant la revendication 15, caractérisé en ce que les éléments (26) envoyant les rayons sont des diodes laser et les éléments (27) recevant ces rayons, des éléments semi-conducteurs photoconducteurs, un de ces éléments semi-conducteurs photodétecteurs étant associé à chaque diode laser.

17. Appareil suivant l'une des revendications 5 à 8, caractérisé en ce qu'il est prévu, le long d'au moins un premier côté (21a) du cadre, une rangée d'éléments récepteurs photodétecteurs (31) disposés côte à côte et en ce qu'un élément (30) envoyant des rayons vers deux côtés diamétralement opposés est disposé au centre du côté (21c) du cadre qui fait face au premier côté, tandis que deux éléments réfléchissants (28a, 28b) pouvant être entraînés suivant un mouvement rotatif sont disposés dans la zone des extrémités de ce second côté (21c) du cadre.

18. Appareil suivant la revendication 17, caractérisé en ce que le susdit élément (30) envoyant des rayons est une double diode laser dont chacune envoie un rayon laser, suivant une direction orientée d'une manière essentiellement parallèle audit second côté (21c) du cadre, vers les deux éléments réfléchissants formés de miroirs (28a, 28b).

19. Appareil suivant la revendication 17 ou 18, caractérisé en ce que les éléments récepteurs photodétecteurs (31) sont constitués par des éléments semi-conducteurs.

20. Appareil suivant une ou plusieurs des revendications 11 à 19, caractérisé en ce que les éléments (24a et 24b, ou 26, ou 30) envoyant les rayons, ainsi que les éléments (25a et 25b, ou 27, ou 31) recevant ces rayons sont reliés, de façon à coopérer avec lui, au dispositif de commande du dispositif de détection.

FIG. 3

FIG. 4

FIG. 5

FIG. 1

0 144 717

FIG. 2

FIG. 6

FIG. 7

4

FIG. 8

FIG. 9

F I G. 10

FIG.11